# FASCICULE DE BREVET EUROPEEN

(11) **EP 0 511 920 B1**
(45) Date de publication et mention de la délivrance du brevet: **27.12.1996**
(21) Numéro de dépôt: 92420141.1
(22) Date de dépôt: 28.04.1992
(51) Int. Cl.: H04M 19/04, G10K 9/13, H03K 17/687

(54) **Circuit d'excitation périodique à niveau variable d'une charge capacitive**
Variable Pegeltreiberschaltung für periodische Ansteuerung einer kapazitiven Last
Variable level driver circuit for periodic excitation of a capacitive load

(30) Priorité: 30.04.1991 FR 9105774
(43) Date de publication de la demande: 04.11.1992
(73) Titulaire: SGS-THOMSON MICROELECTRONICS SA, 94250 Gentilly (FR)
(72) Inventeur: Gens, Marc, F-38410 Saint Martin d'Uriage (FR)
(74) Mandataire: de Beaumont, Michel

(56) Documents cités:
- EP-A- 0 299 292
- EP-A- 0 311 957
- US-A- 4 214 131
- N.T.I.S. TECH NOTES Février 1988, SPRINGFIELD, VA - USA G.A. PRAVER ET AL.: 'Power-Switching Circuit'
- Page 81, 1-2
- PATENT ABSTRACTS OF JAPAN vol. 009, no. 274 (E-354)31 Octobre 1985 & JP-A-60 117 843 ( SHARP K.K. ) 25 Juin 1985
- EDN vol. 31, no. 14, 10 Juillet 1986, BOSTON, MA USA pages 74 - 84; BILL TRAVIS: 'High-Voltage Circuits use Mixed Processes, fulfill diverse roles'
- IBM TECHNICAL DISCLOSURE BULLETIN vol. 16, no. 8, Janvier 1974, pages 2679 - 2680; J.C. ELLIOTT AT AL.: 'Self-Limiting Off-Chip Driver'
- TELECOMMUNICATION DEVICE DATA - MOTOROLA DATABK DL 136 - REV 2 - Series C; Pages 3-52 to 3-60 MOTOROLA Inc., 1989

## Description

La présente invention concerne un circuit d'excitation à fréquence donnée et à niveau variable d'une charge capacitive, tel qu'un vibreur piézoélectrique servant de sonnerie dans un poste de téléphone.

Généralement, la sonnerie d'un poste de téléphone est à niveau variable. Dans les postes haut de gamme, la sonnerie est obtenue par un haut-parleur alimenté par un signal carré de fréquence donnée (de l'ordre du kilohertz). Le haut-parleur est piloté par un amplificateur dont le gain est programmable par l'action d'un opérateur sur des touches du poste de téléphone.

Dans les postes de téléphone bas de gamme, la sonnerie est constituée par un vibreur piézoélectrique excité par le même signal carré. En général, le niveau sonore du vibreur est fixé par un potentiomètre monté en série avec le vibreur. Dans un tel poste bas de gamme, l'installation d'un potentiomètre variable est coûteuse et son utilisation est peu pratique. Il serait a priori moins coûteux de régler le niveau sonore par l'intermédiaire des touches du poste.

Toutefois, la réalisation d'un amplificateur à gain programmable pour un vibreur piézoélectrique pose des problèmes. En effet, un vibreur piézoélectrique est une charge fortement capacitive risquant d'entraîner une instabilité de l'amplificateur. L'amplificateur devrait être soigneusement conçu et compensé avec des capacités relativement importantes. Par conséquent, un tel amplificateur reviendrait bien plus cher que l'amplificateur utilisé pour les haut-parleurs.

On ne peut pas envisager non plus, un amplificateur à modulation de largeur d'impulsion. Un vibreur piézoélectrique présente plusieurs pics de résonance à des fréquences différentes. En général, le vibreur est excité par un signal carré de rapport cyclique 50 % à une fréquence proche de l'une des fréquences de résonance. Le signal carré de rapport cyclique 50 % possède des harmoniques d'amplitude rapidement décroissante venant exciter faiblement d'autres pics de résonance. Lorsqu'on diminue le rapport cyclique du signal d'excitation, les amplitudes et le nombre des harmoniques croissent et peuvent exciter d'autres pics de résonance, ce qui peut entraîner une variation insuffisante du niveau sonore.

Un objet de la présente invention est de réaliser un circuit permettant une variation de niveau sonore programmable évitant les inconvénients susmentionnés.

Cet objet est atteint grâce à un circuit d'excitation à fréquence donnée et à niveau réglable d'une charge capacitive comportant une première borne reliée à une tension de référence, le circuit comprenant : deux interrupteurs reliés en série entre une tension d'alimentation et la tension de référence, le point de connexion des deux interrupteurs étant couplé à la deuxième borne de la charge, ces deux interrupteurs n'étant pas simultanément fermés ; un circuit de commande périodique à la fermeture de l'interrupteur relié à la tension d'alimentation ; et des moyens de régulation agissant sur le circuit de commande pour ouvrir un des interrupteurs lorsque la tension aux bornes de la charge atteint une valeur prédéterminée.

Selon un mode de réalisation de la présente invention, le circuit de commannde comprend une entrée de signal de commande logique périodique, une première sortie pilotant un des interrupteurs en phase avec le signal de commande, une deuxième sortie pilotant l'autre interrupteur en opposition de phase avec le signal de commande, et une entrée de mise à haute impédance qui, en réponse à un signal de mise à haute impédance, provoque l'ouverture dudit interrupteur au moins jusqu'au changement d'état suivant du signal de commande.

Selon un mode de réalisation de la présente invention, les moins de régulation comprennent un comparateur dont la sortie est reliée à l'entrée de mise à haute impédance du circuit de commande, dont une entrée de comparaison reçoit une tension de consigne et dont l'autre entrée de comparaison est couplée à la deuxième borne de la charge.

Selon un mode de réalisation de la présente invention, le circuit de commande comprend, pour chacun des interrupteurs, un moyen de détection du courant de l'interrupteur qui ouvre l'autre interrupteur si le courant détecté dépasse une valeur prédéterminée.

Ces objets, caractéristiques et avantages ainsi que d'autres de la présente invention seront exposés plus en détail dans la description suivante de modes de réalisation particuliers faite en relation avec les figures jointes parmi lesquelles :
la figure 1 illustre un schéma de principe d'un mode de réalisation de la présente invention ;
la figure 2 représente un ensemble de courbes illustrant un mode de fonctionnement du circuit de la figure 1 ;
la figure 3 représente un ensemble de courbes illustrant un autre mode de fonctionnement du circuit de la figure 1 ; et
la figure 4 illustre un exemple de réalisation d'un des éléments du circuit de la figure 1.

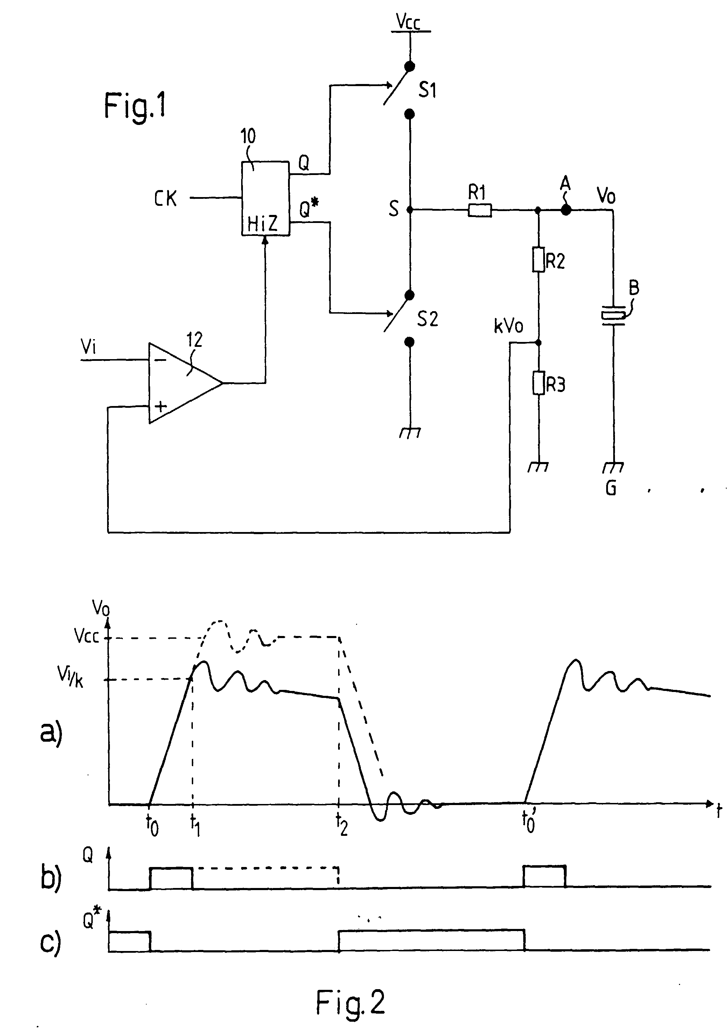

A la figure 1, on a représenté un vibreur piézoélectrique B comportant une borne reliée à la masse G et une borne A reliée par l'intermédiaire d'une résistance R1 à un point S. Un interrupteur S1 est relié entre une borne d'alimentation Vcc et le point S, et un interrupteur S2 est relié entre le point S et la masse G. Les interrupteurs S1 et S2 sont respectivement pilotés par des sorties Q et Q* d'un circuit de commande 10. Le circuit de commande 10 comprend une entrée recevant le signal d'excitation CK du vibreur (signal carré de rapport cyclique 50%) et un signal de mise à haute impédance HiZ fourni par la sortie d'un comparateur 12. L'entrée inverseuse du comparateur 12 reçoit une tension de consigne Vi et l'entrée non inverseuse reçoit la tension Vo présente à la borne A du vibreur, divisée par un pont de résistance R2 et R3. La tension présente sur l'entrée non-inverseuse du comparateur est égale à kVo, où k est le coefficient multiplicateur (inférieur à 1) du pont diviseur R2, R3.

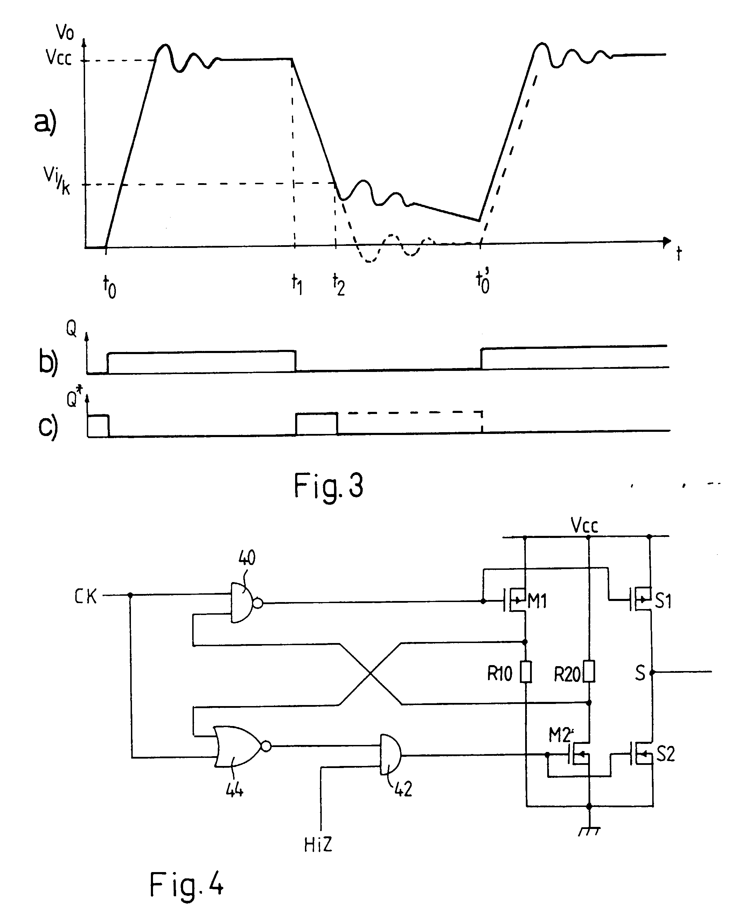

Le circuit de la figure 1 peut fonctionner selon deux modes différents qui seront décrits en relation avec les figures 2 et 3.

La figure 2 représente un ensemble de courbes illustrant un premier mode de fonctionnement du circuit selon la présente invention représenté en figure 1. La courbe a) illustre la tension Vo aux bornes du vibreur B au cours du temps t en fonction des signaux Q et Q* pilotant les interrupteurs S1 et S2. La courbe b) illustre la variation du signal Q au cours du temps, un état bas du signal Q correspondant à une ouverture de l'interrupteur S1 et un état haut correspondant à la fermeture de l'interrupteur S1. La courbe c) illustre les variations du signal Q* au cours du temps, un état bas du signal Q* correspondant à l'ouverture de l'interrupteur S2 et un état haut correspondant à la fermeture de l'interrupteur S2. Le signal d'excitation CK correspond au complément logique du signal Q* et n'est pas représenté.

Initialement, le signal Q est à l'état bas et le signal Q* est à l'état haut, l'interrupteur S1 est ouvert et l'interrupteur S2 est fermé. La tension Vo aux bornes du vibreur est nulle. A un instant t₀ le signal d'excitation CK est appliqué au circuit 10. Le signal Q passe à niveau haut, l'interrupteur S1 est fermé et l'interrupteur S2 est ouvert. La tension Vo grimpe rapidement, ce qui correspond à la charge de la composante capacitive du vibreur B à travers la résistance R1. Lorsque, à un instant t₁, la tension Vo atteint Vi/k (lorsque la tension sur l'entrée non-inverseuse du comparateur 12 atteint la valeur de consigne Vi) le comparateur 12 bascule à un état provoquant l'ouverture de l'interrupteur S1 par le circuit de commande 10, l'interrupteur S2 restant ouvert. L'interrupteur S1 sera maintenu ouvert jusqu'au prochain front montant du signal CK. La tension Vo cesse de grimper, présente quelques oscillations autour de Vi/k correspondant à l'excitation d'un deuxième pic de résonance du vibreur B, et diminue lentement, ce qui correspond à la décharge de la capacité du vibreur B à travers le pont de résistance R2, R3. A un instant t₂, le signal d'excitation CK passe au niveau bas, l'interrupteur S2 se ferme et décharge rapidement la capacité du vibreur à travers la résistance R1, la tension Vo chute brusquement jusqu'à zéro et présente quelques oscillations. A un instant t′₀, le cycle recommence...

Ainsi, l'amplitude du signal Vo peut être réglée en modifiant la tension de consigne Vi, ce qui correspond à un réglage du niveau sonore émis par le vibreur. On a représenté en pointillés l'allure de la tension Vo et le signal Q correspondant, pour une tension de consigne Vi telle que Vi/k = Vcc. Ceci correspond au niveau sonore maximum.

On notera ici la différence entre ce mode de fonctionnement et une commande par modulation de largeur d'impulsion. En effet, dans le cas d'une commande par modulation de largeur d'impulsion, on utilise des signaux Q et Q* complémentaires, c'est-à-dire qu'il existe tout au plus une phase très brève pendant laquelle les interrupteurs S1 et S2 sont simultanément ouverts. Par contre, selon la présente invention, les interrupteurs S1 et S2 sont simultanément ouverts entre les instants t₁ et t₂.

La figure 3 représente un ensemble de courbes illustrant un autre mode de fonctionnement du circuit selon la présente invention. Les courbes a), b), et c) illustrent les mêmes courbes que la figure 2. Ici, le signal Q est identique au signal d'excitation CK.

A un instant initial, l'interrupteur S1 est ouvert, l'interrupteur S2 est fermé, et la tension Vo est nulle. A un instant t₀, le signal Q (ou le signal CK) passe à un état haut et le signal Q* passe à un état bas. Ces états sont maintenus pendant la demi-période du signal carré CK. La tension Vo grimpe rapidement jusqu'à sa tension d'alimentation Vcc, présente quelques oscillations et se stabilise à Vcc. A un instant t₁, on atteint la demi-période du signal CK, l'interrupteur S1 est ouvert et l'interrupteur S2 est fermé. La tension Vo chute rapidement jusqu'à un instant t₂ où elle atteint la valeur Vi/k et où le comparateur 12 bascule et provoque l'ouverture de l'interrupteur S2. La tension Vo cesse de chuter rapidement, présente quelques oscillations et diminue progressivement, ce qui correspond à la décharge de la capacité du vibreur dans le pont diviseur R2, R3. Le cycle recommence à un instant t′₀.

On a représenté en pointillés l'allure de la tension Vo et le signal Q* correspondant, pour une tension de consigne Vi telle que Vi/k = 0. Ces allures correspondent au maximum de niveau sonore du vibreur. Le minimum du niveau sonore sera obtenu pour Vi/k = Vcc où Vo sera sensiblement égal à Vcc.

Ce mode de fonctionnement permet une réalisation plus simple du circuit de commande 10. En effet, une fois que la tension Vo a atteint Vi/k, la tension Vo reste inférieure à Vi/k et donc le comparateur 12 ne rebascule plus à son état initial pendant tout le restant de la demi-période du signal CK en maintenant l'interrupteur S2 ouvert ; alors que pour le mode de fonctionnement précédent, il fallait réaliser le circuit de commande 10 de telle manière que l'interrupteur S1 ne soit pas refermé pendant la demi-période du signal CK, car le comparateur rebasculait à son état initial pratiquement aussitôt la valeur Vi/k atteinte. Le circuit de commande 10 pour le mode de fonctionnement de la figure 2 peut être simplifié en reliant la résistance R3 à la tension d'alimentation Vcc au lieu de la masse.

La figure 4 représente un exemple simplifié de réalisation du circuit de commande 10 permettant d'obtenir le mode de fonctionnement de la figure 3. L'interrupteur S1 est réalisé à partir d'un transistor MOS à canal P dont la source est reliée à la tension Vcc, dont le drain est relié au point S et dont la grille est reliée à la sortie d'une porte NON ET 40. L'interrupteur S2 est réalisé à partir d'un transistor MOS à canal N dont la source est relié à la masse, dont le drain est relié au point S et dont la grille est reliée à la sortie d'une porte ET 42. Une première entrée de la porte ET 42 reçoit le signal HiZ fourni par la sortie du comparateur 12. La deuxième entrée de la porte ET 42 est reliée à la sortie d'une porte NON OU 44. Une première entrée de la porte NON ET 40 et de la porte NON OU 44 reçoivent le signal d'excitation CK.

Dans un premier temps, on ignorera les autres éléments du circuit non encore décrits et on supposera que la deuxième entrée de la porte NON ET 40 est à "1" et que la deuxième entrée de la porte NON OU 44 est à "0". Ansi, les portes 40 et 44 se comportent comme des inverseurs. Lorsque le signal CK est à "1", la sortie de la porte 40 est à "0" et le transistor MOS S1 est passant. La sortie de la porte 44 est également à "0", alors, quel que soit l'état du signal HiZ la sortie de la porte 42 est à "0" et le transistor MOS S2 est bloqué. Lorsque le signal CK est à 0", la sortie de la porte 40 est à "1" et le transistor S1 est bloqué. La sortie de la porte 44 est à "1" et la sortie de la porte 42 est à "1" seulement si le signal HiZ est à "1", ce qui est le cas quand Vo > Vi/k. Alors, le transistor S2 est passant. Si Vo < Vi/k, la sortie de la porte 42 est à "0" et le transistor S2 est bloqué.

Toutefois, le circuit tel qu'il est décrit précedemment, présente un inconvénient. A l'instant t₁ et éventuellement l'instant t′₀ (figure 3), les interrupteurs S1 et S2 peuvent être simultanément fermés pendant un bref instant, par suite de retards de commutation. Comme les transistors S1 et S2 doivent être dimensionnés pour véhiculer des courants relativement importants d'excitation du vibreur B, le courant qui les traverserait pendant l'intervalle où ils sont simultanément fermés peut être très important et détruire les transistors. Les éléments décrits ci-après du circuit de commande selon la présente invention remédient à cet inconvénient.

Un transistor MOS à canal P M1, de plus petite taille que le transistor S1, est relié en parallèle sur la source et la grille du transistor S1. Le drain du transistor M1 est relié à la masse par l'intermédiaire d'une résistance R10 et à la deuxième entrée de la porte NON OU 44. Un transistor MOS à canal N M2, de plus petite taille que le transistor S2, est relié en parallèle sur la source et la grille du transistor S2. Le drain du transistor M2 est relié à la tension d'alimentation Vcc par l'intermédiaire d'une résistance R20 et à la deuxième entrée de la porte NON ET 40. Avec cette configuration, le courant dans le transistor M1 est proportionnel au courant dans le transistor S1 et le courant dans le transistor M2 est proportionnel au courant dans le transistor S2. Ces courants sont convertis en une tension aux bornes des résistances R10 et R20. La résistance R10 est choisie pour que la tension à ses bornes soit égale à la tension seuil de la porte 44 lorsque le courant dans le transistor S1 atteint une valeur limite. De même, la résistance R20 est choisie pour que la tension aux bornes du transistor M2 atteigne la tension seuil de la porte 40 lorsque le courant dans le transistor S2 atteint la valeur limite.

Ainsi, lorsque le courant dans le transistor S1 dépasse la valeur limite, la tension aux bornes de la résistance R10 correspond à un niveau logique 1 et la sortie de la porte 44 est alors forcée à "0", ce qui entraîne le blocage du transistor S2. De même, si le courant dans le transistor S2 dépasse la valeur limite, la tension aux bornes de la résistance R20 est telle que la tension drain/source du transistor M2 corresponde à un niveau logique "0", la sortie de la porte 40 est alors forcée à "1", ce qui entraîne le blocage du transistor S1. En fait, ce dispositif de limitation fonctionne en régime linéaire, ce qui a pour conséquence une régulation du courant dans les transistors S1 et S2 à la valeur limite lorsqu'ils sont simultanément passants.

Les circuits de la présente invention sont particulièrement rapides s'ils sont réalisés en technologie bipolaire-MOS (BIPMOS).

La présente invention a été décrite dans le cadre de l'excitation d'un vibreur piézoélectrique, mais elle s'applique à l'excitation de n'importe quelle charge capacitive. De nombreuses variantes et modifications de la présente invention apparaîtront à l'homme de l'art, notamment en ce qui concerne les diverses possibilités de réalisation du circuit de commande 10.

Bien que cela n'ait pas été décrit ci-dessus, l'homme de l'art notera qu'il existe de nombreux circuits connus pour ajuster une tension de consigne Vi à la suite de l'actionnement de touches.

## Revendications

1. Circuit d'excitation à fréquence donnée et à niveau réglable d'une charge capacitive (B) dont une première borne est reliée à une tension de référence (G), comprenant :
- deux interrupteurs (S1, S2) reliés en série entre une tension d'alimentation (Vcc) et la tension de référence (G), le point de connexion (S) des deux interrupteurs étant couplé à la deuxième borne (A) de la charge ;
- un circuit (10) de commande périodique des deux interrupteurs en opposition de phase ; et
- des moyens de régulation (R2, R3, 12) agissant sur le circuit de commande pour ouvrir un premier des interrupteurs lorsque la tension aux bornes de la charge atteint une valeur prédéterminée.

2. Circuit d'excitation selon la revendication 1, dans lequel le circuit de commande comprend une entrée de signal de commande logique périodique (CK), une première sortie (Q) pilotant un des interrupteurs (S1) en phase avec le signal de commande, une deuxième sortie (Q^{*}) pilotant l'autre interrupteur (S2) en opposition de phase avec le signal de commande, et une entrée de mise à haute impédance (HiZ) qui, en réponse à un signal de mise à haute impédance, provoque l'ouverture dudit premier des interrupteurs au moins jusqu'au changement d'état suivant du signal de commande (CK).

3. Circuit d'excitation selon la revendication 2, dans lequel les moyens de régulation comprennent un comparateur (12) dont la sortie est reliée à l'entrée de mise à haute impédance (HiZ) du circuit de commande (10), dont une entrée de comparaison reçoit une tension de consigne (Vi) et dont l'autre entrée de comparaison est couplée à la deuxième borne (A) de la charge (B).

4. Circuit d'excitation selon la revendication 2, dans lequel le circuit de commande (10) comprend, pour chacun des interrupteurs, un moyen de détection (M1, M2) du courant de l'interrupteur qui ouvre l'autre interrupteur si le courant détecté dépasse une valeur prédéterminée.

5. Circuit d'excitation selon la revendication 1, dans lequel ledit premier des interrupteurs est celui des interrupteurs dont la fermeture provoque la décharge de la charge capacitive.

## Patentansprüche

1. Erregungsschaltung mit vorgegebener Frequenz und regelbarem Pegel für eine kapazitive Last (B), wobei ein erster Anschluß mit einer Bezugsspannung (G) verbunden « ist und folgendes vorgesehen ist:
- zwei zwischen einer Versorgungsspannung (Vcc) und der Bezugsspannung (G) in Serie geschaltete Schalter (S1,S2), deren Verbindungspunkt (S) mit dem zweiten Anschluß (A), dem Lastanschluß, verbunden ist;
- eine Schaltung (10) zum periodischen Steuern der zwei Schalter mit entgegengesetzter Phase; und
- Regelmittel (R2,R3,12), die auf die Steuer-schaltung einwirken, um einen ersten der Schalter zu öffnen, wenn die Spannung an den Lastanschlüssen einen vorbestimmten Wert erreicht.

2. Erregungsschaltung nach Anspruch 1, wobei die Steuerschaltung folgendes aufweist:
- einen logischen periodischen Steuersignaleingang (CK), einen ersten Ausgang (Q), der einen der Schalter (S1) in Phase mit dem Steuersignal steuert, einen zweiten Ausgang (Q^{*}), der den anderen Schalter (S2) mit entgegengesetzter Phase mit dem Steuersignal steuert und ein Hochimpedanzeinstelleingang (HiZ), der infolge eines Hochimpedanzeinstellsignals das Öffnen des ersten der Schalter hervorruft und zwar mindestens bis zur nächsten Zustandsänderung des Steuersignals (CK).

3. Erregungsschaltung nach Anspruch 2, wobei die Regelmittel einen Komparator (12) aufweisen, dessen Ausgang mit dem Hochimpedanzeinstelleingang (HiZ) der Steuerschaltung (10) verbunden ist, wobei ein Vergleichs-eingang des Komparators ein Bezugsspannungssignal (Vi) empfängt und der andere Vergleichseingang mit dem zweiten Anschluß (A) der Last (B) gekoppelt ist.

4. Erregungsschaltung nach Anspruch 2, wobei die Steuerschaltung (10) für jeden der Schalter ein Detektiermittel (M1,M2) aufweist und zwar für den Schalterstrom, der den anderen Schalter öffnet, wenn der detektierte Strom einen vorbestimmten Wert übersteigt.

5. Erregungsschaltung nach Anspruch 1, wobei der erwähnte erste Schalter derjenige der Schalter ist, dessen Schließen eine Entladung der kapazitiven Last hervorruft.

## Claims

1. A predetermined frequency and adjustable level excitation circuit for a capacitive load (B) having a first terminal connected to a reference voltage (G), comprising:
- two switches (S1, S2) connected in series between a supply voltage (Vcc) and said reference voltage (G), the junction (S) of said two switches being coupled to the second terminal (A) of the load;
- a circuit (10) for periodically controlling the switches in phase opposition; and
- regulation means (R2, R3, 12) acting on the control circuit for opening a first of the switches when the voltage across the load reaches a predetermined value.

2. An excitation circuit according to claim 1, wherein said control circuit comprises a periodic logic control signal (CK) input, a first output (Q) controlling one of the switches (S1) in phase with the control signal, a second output (Q^{*}) controlling the other switch (S2) in phase opposition to the control signal, and a high impedance setting input (Hiz) which, in response to a high impedance setting signal, causes said switch to be opened at least until the next state transition of the control signal (CK).

3. An excitation circuit according to claim 2, wherein the regulation means comprise a comparator (12), the output of which is connected to said high impedance setting input (HiZ) of the control circuit (10), a comparison input of which receives a reference voltage (Vi) and the other comparison input of which is coupled to the second terminal (A) of the load (B).

4. An excitation circuit according to claim 2, wherein the control circuit (10) comprises, for each switch, a means (M1, M2) for detecting the current in the switch, which opens the other switch if the detected current exceeds a predetermined value.

5. An excitation circuit according to claim 1, wherein said first of the switches is that which produces a discharge of the capacitive load when closed.
